# EUROPEAN PATENT SPECIFICATION

(11) **EP 2 435 597 B1**
(45) Date of publication and mention of the grant of the patent: **17.10.2018**
(21) Application number: 10726140.6
(22) Date of filing: 21.05.2010
(51) Int. Cl.: C23C 16/458, C23C 16/455

(54) **ARRANGEMENT FOR PROCESSING SUBSTRATE AND SUBSTRATE CARRIER**
ANORDNUNG ZUR SUBSTRATVERARBEITUNG UND SUBSTRATTRÄGER
AGENCEMENT POUR LE TRAITEMENT D'UN SUBSTRAT ET SUPPORT DE SUBSTRAT

(30) Priority: 26.05.2009 FI 20095578
(43) Date of publication of application: 04.04.2012
(73) Proprietor: Beneq Oy, 01510 Vantaa (FI)
(72) Inventor: MAULA, Jarmo, 02200 Espoo (FI)
(74) Representative: Boco IP Oy Ab
(86) International application number: PCT/FI2010/050408
(87) International publication number: WO 2010/136644

(56) References cited:
- WO-A2-2009/024460
- US-A- 3 814 051
- US-A1- 2007 062 455
- US-A1- 2008 182 101

## Description

### FIELD OF THE INVENTION

The present invention relates to an arrangement for processing a substrate and, in particular, to an arrangement in accordance with the preamble of claim 1 for processing a substrate in a reaction chamber of a gas deposition apparatus by exposing the substrate to alternate saturated surface reactions of starting materials, the arrangement comprising loading means for loading the substrate into the reaction chamber on a substrate support. The present invention also relates to a carrier and, in particular, to a carrier in accordance with the preamble of claim 6 for supporting the substrate in a reaction space of a gas deposition apparatus as the substrate is processed by exposing it to alternate saturated surface reactions of starting materials.

### BACKGROUND OF THE INVENTION

In prior art gas deposition apparatuses, such as atomic layer deposition (ALD) apparatuses, in which a substrate is exposed to alternate saturated surface reactions of starting materials, comprise a carrier or a substrate support onto which the substrate is placed for loading into the reaction chamber of the gas deposition apparatus. In other words, the carrier or the substrate support is used for introducing the substrate or substrates to be processed into the reaction chamber so as to support the substrates inside the reaction chamber during the processing and to remove the substrates from the reaction chamber. Prior art substrate supports comprise a support plane, on which the substrate is placed, for instance, in a substantially horizontal position, from the horizontal position to an inclined position or to a substantially vertical position. Use of cassette-like substrate supports is also known. In these cassette-like substrate supports it is possible to place a plurality of substrates side by side on the support planes, for instance, in horizontal, vertical or inclined positions.

A problem with these prior art substrate supports or carriers is that placing of substrates into the reaction chamber in a substantially vertical position for coating is cumbersome and extremely complicated solution are needed for the substrate supports or carriers. In this connection the upright, i.e. vertical position refers to the position of the substrate in which the main surface of the substrate or the surfaces to be coated, such as silicon wafer surfaces, are substantially in vertical position in the reaction chamber. It is a demanding task to place the substrates in vertical position, because the substrates must be held in place by means of the substrate support without covering, however, the surface to be coated by gripping it, for instance. Another problem associated with the prior art substrate supports or carriers is that they are not capable of efficiently preventing backside deposition of a coating in the gas deposition reactor. Backside deposition refers to one or more coating layers deposited on the backside, e.g. against the carrier, of the substrate to be coated, which often is undesirable. Backside deposition results from excellent conformalness of gas deposition methods, in which the substrate is exposed to alternate surface reactions of starting materials, when the coating tends to deposit on all surfaces of the substrate. Prior art arrangements for preventing backside deposition have included complicated and expensive solutions, such as flow control of the flush gas flow to the backside of the substrate by placing a highly porous piece having a large effective surface area behind the substrate, whereby the coating will be deposited on this porous piece, or by placing the substrate on a substrate carrier that is as planar and even as possible.

US3814051 discloses a coating apparatus comprising a substrate holder to which a plurality of substrates are attached by means of double adhesive surface tape.

### BRIEF DESCRIPTION OF THE INVENTION

The object of the invention is thus to provide an arrangement and a carrier for processing a substrate in a reaction chamber of a gas deposition apparatus such that the above problems may be solved. The object of the invention is achieved by the arrangement of the characterizing part of claim 1, which includes the feature that the substrate is arranged to be detachably connected to the substrate support by means of an adhesive. The object of the invention is further achieved by a carrier in accordance with the characterizing part of claim 6, which includes the feature that the carrier comprises an adhesive layer for attaching the substrate detachably to the carrier.

The preferred embodiments of the invention are disclosed in the dependent claims.

The invention is based on the idea that a substrate is attached detachably to a substrate support or carrier by means of an adhesive. The adhesive may be applied to the support or carrier, and the substrate is attached thereto, for instance, by pressing the substrate against the adhesive. Alternatively, the adhesive may be applied onto the surface of the substrate for attachment to the support or carrier. The adhesive may be any adhesive that may be applied onto the substrate support or onto the substrate and that enables detachable attachment of the substrate to the support or carrier. Alternatively, it is possible to use an adhesive tape-like structure for attaching the substrate to the carrier, the structure comprising at least on one side thereof an adhesive layer. In that case the tape may be placed on the substrate support or carrier and the substrate may be further attached to the adhesive layer of the tape. The tape may also comprise an adhesive layer on both sides such that the adhesive layer on the first side is placed against the support or the carrier and the substrate is attached to the adhesive layer on the second side. In that case the adhesive tape serves as the attachment means between the substrate and the support or carrier. Alternatively, the tape-like structure may be used as such as the carrier, to which the substrate is attached on the adhesive layer of the tape-like structure and the base material of the tape-like structure serves as a substrate support or carrier.

The method and arrangement of the invention have an advantage that by means of the adhesive or the adhesive layer of the tape-like structure it is easy and simple to attach the substrate to the carrier or the substrate support. Attachment of the substrate, carried out by means of the adhesive, enables the substrate to be loaded and placed in vertical position in the reaction chamber. In that case no complicated and expensive solutions are needed for vertical substrate positions in the substrate supports. At the same time an adhesive layer attaches the substrate tightly to the substrate support, carrier or base material of the tape-like structure thus preventing backside deposition on the attachment area of the adhesive. Thus the present invention makes it possible to combine two separate prior art problems by means of one single solution such that the problems associated with both the vertical substrate position and the backside deposition can be solved in a simple manner. Hence, it is possible to avoid complicated substrate supports and solutions associated therewith.

### DETAILED DESCRIPTION OF THE INVENTION

The present invention relates to gas deposition apparatuses, in which a substrate to be coated is exposed to alternate saturated surface reactions of starting materials. An example of these gas deposition methods and apparatuses is an atomic layer deposition method (ALD method) and apparatuses thereof, which produce one deposition layer, such as atomic layer, at a time on the surface of the substrate. A typical feature in these gas deposition methods is their good conformalness, i.e. uniformity, that makes the coating grow evenly on all surfaces of the substrate. The gas deposition apparatus comprises a reaction chamber, into which the substrate or substrates is introduced for processing or coating them. Gaseous starting materials are fed into the reaction chamber such that the surface of the substrate is exposed to alternate, saturated surface reactions so as to provide deposition layers on the surface of the substrate. The substrate is introduced into the reaction chamber by means of a substrate support or carrier. The substrate support as a whole refers to the part or parts of the gas deposition apparatus, on which the substrate is placed and supported for introducing the substrate into the reaction chamber for processing therein and removing therefrom. The carrier, in turn, refers to a support, a plane, a surface or the like, on which the substrate is placed for introducing into, processing and removing from the reaction chamber. The gas deposition apparatus may also comprise loading means, preferably automated, for loading the substrate into the reaction chamber on the substrate support or carrier. In general, the substrate is placed on the substrate support or carrier such that the side of the substrate which is not to be coated is against the substrate support or carrier, and correspondingly, the side of the substrate to be coated is placed away or apart from the substrate support or carrier.

In a first embodiment of the present invention a gas deposition apparatus comprises an arrangement, in which a substrate is arranged to be detachably attached to a substrate support by means of an adhesive. As the adhesive it is possible to use any suitable adhesive by means of which the substrate may be detachably attached to the substrate support. In that case the substrate support may be furnished with an adhesive or an adhesive layer to which the substrate may be attached. The adhesive may be applied on the entire surface of the substrate support, to which one or more substrates will be attached, or on just a portion of that surface. Alternatively, the substrate support may comprise one or more separate attachment means, such as attachment support, attachment pin, attachment plane or the like, which may be mounted detachably or replaceably on the substrate support. This separate attachment means to be mounted on the substrate support thus comprises an adhesive layer for attaching the substrate to the substrate support. The separate attachment means may be, for instance, a tape-like structure that comprises a base material on the first side of which there is a first adhesive layer for attaching the substrate to the tape-like structure. The tape-like structure may be mounted on the substrate support, for instance, by mechanical attachment, adhesive attachment or glue, such as the adhesive layer on the first side. The tape-like structure may further comprise a second adhesive layer on its second side for attaching the tape-like structure to the substrate support and/or for attaching the substrate to the tape-like structure. In other words, the tape-like structure may be e.g. a double-sided tape, on the first and second sides of which it is possible to attach one or more substrates. In that case the tape-like structure may be mounted on the substrate support, for instance, such that it hangs from the substrate support, or alternatively, the substrate support may comprise pins, lugs or the like, around which the tape-like structure is wrapped such that it extends therebetween and to which the tape-like structure is attached by means of its adhesive layer. The tape-like structure may also be attached onto the surface of the substrate support by pressing the second adhesive layer on the second side thereof against the surface of the substrate support.

The substrate support may also consist of a substantially completely tape-like structure, which comprises a base material and an adhesive layer on the first side thereof. However this is not an embodiment of the current invention. In this solution the tape-like structure may also comprise a second adhesive layer on its second side. In that case the tape-like structure comprises, on the first and second sides of the base material, an adhesive layer, to which first and second adhesive layers one or more substrates are attachable. The reaction chamber may comprise one or more mounting pieces or the like, to which the tape-like structure is attached inside the reaction chamber to extend between these mounting pieces, for instance. In this solution the actual substrate support may consist of a substantially completely tape-like structure and other parts are not necessarily needed for the substrate support. The tape-like structure may be utilized, for instance, such that a strip to be coated or the like is first attached on its first side to the first adhesive layer of the tape and then the strip is cut into shorter bits the bits remaining attached to the tape. Thereafter is performed the second-side coating of the strip or the bits, for instance, by a gas deposition method. Then a second tape having a stronger adhesive layer is attached on the strip, or the bits cut therefrom, on the second coated side thereof, and the first tape is removed. Thereafter the second side of the strip, or the bits cut therefrom, is coated by a gas deposition method, for instance. Thus, the both sides of the strip or another similar planar product can be coated in an alternate manner and optionally with different coatings. In the above it should be noted that this procedure may also be applied to any product, in which any one of the surfaces are to be coated separately. If so desired, the cutting into bits may also be omitted. Another application consists of conveying a tape-like substrate support continuously through the reaction chamber the substrates being attached to the tape-like substrate support.

The above described tape-like structure may be arranged for being placed in the reaction chamber in a straight position, bent position, horizontal position, vertical position, inclined position, folded position, spiral position or some other shaped position, in which substrates may be attached to one or both sides of the tape-like structure.

The tape-like structure may also be a strip, a strip-like or another elongated structure, which may be guided through one or more gas deposition apparatuses and the reaction chamber thereof. In that case the substrates are attached to the strip-like structure by means of an adhesive, whereby the substrates as well may be conveyed through one or more gas deposition apparatuses in order for exposing the surface of the substrate to the surface reactions of starting materials. In that case the apparatus may operate on a reel-to-reel principle, in which the strip-like structure, to which the substrate is attached, is run from a first reel via the reaction chamber of at least one gas deposition apparatus onto a second reel. In this manner it is possible to reach a very high coating speed, because the strip-like structure may be run at high speed through the reaction chamber. The substrate may thus be conveyed through one or more reaction chambers of one gas deposition apparatus and/or through two or more gas deposition apparatuses.

Another alternative to coat a substrate is to guide a strip-like or elongated tape-like structure through the reaction chamber of a gas deposition apparatus such that a substrate is conveyed successively through different starting material zones. In that case the reaction chamber is provided with two or more starting material zones, whereto different starting materials are fed. The strip-like structure is then conveyed successively one or more times through different starting material zones, whereby the substrate is exposed to surface reactions of different starting materials. Thus, the substrate may be conveyed through the reaction chamber such that inside one reaction chamber the substrate may be exposed several times to different starting materials so as to produce several deposition layers on the surface of the substrate without having to pulse the starting material feed into the reaction chamber.

When desired, the adhesive may be provided, for instance by spreading or otherwise applying it, directly on the surface of the substrate. In that case the substrate may be placed on the substrate support such that the adhesive is pressed against the substrate support in order for the substrate to be attached to the substrate support.

The adhesive, adhesive layer or tape-like structure is provided to cover, completely or partly, the surface of the substrate support to which the substrate is attached. In other words, the surface of the substrate support onto which one or more substrates are attached is provided with an adhesive or adhesive layer either throughout its surface area or only for a portion of its surface area. Thus the surface of the substrate support, onto which the substrate is attached, may be provided throughout its surface or for only a portion of the surface with the above-described tape-like structure. In that case in the substrate support it is possible to produce, for instance, two or more attachment points provided with an adhesive or a tape-like structure, each one of which is arranged to attach one or more substrates. The adhesive, the adhesive layer or tape-like structure may further be provided such that it covers the surface at which the substrate is attached to the substrate support or the surface which is against the substrate support, completely or partly. The substrate may then be attached, by means of an adhesive, to the substrate support or to the tape-like structure throughout the surface that is against the substrate support, or for only a portion of said surface.

As the substrate is attached to the substrate support or tape-like structure with an adhesive it is possible to place the substrate in the reaction chamber in a desired position without recourse to complicated support solutions. The substrate support and/or the substrate may thus be arranged for placement in the reaction chamber, for instance, in substantially horizontal position, vertical position or angular position between the horizontal and the vertical positions.

The adhesive or adhesive layer as described above is arranged to substantially prevent the substrate from being exposed to surface reactions in the areas covered by the adhesive or the adhesive layer. Thus, by means of the adhesive, it is possible to prevent the undesirable backside deposition. In addition, when necessary, the adhesive may be utilized as a mask at a particular point of the substrate where no deposition is desired. In that case the adhesive or the adhesive layer, for instance, may have been provided such that only a particular location, area or shape on the a surface of the substrate is covered thereby, while it simultaneously attaches the product to the substrate support or the tape-like structure.

The solution in accordance with the present invention may also be implemented in connection with a carrier for supporting a substrate in a reaction chamber of a gas deposition apparatus when the substrate is processed by exposing it to alternate, saturated surface reactions of starting materials. In accordance with the invention, the carrier comprises an adhesive layer for attaching the substrate detachably to the carrier. The carrier may be any base, plate, plane, mounting support or the like, on which the substrate is placed for introducing it into the reaction chamber and for processing therein. The carrier may be a separate piece wherewith the substrate is introduced into the reaction chamber and whereon it is placed during the processing, or it may be part of the substrate support. According to the invention, the carrier consists of one or more planes, and it is a cassette-like structure, which comprises a plurality of adjacent planes or mounting supports, each one of which is arranged to receive one or more substrates. Thus, the carrier comprises an adhesive layer on one or more sides of each support included in the cassette-like structure.

The carrier may also comprise a tape-like structure to the adhesive layer of which the substrate is arranged for being attached. The tape-like structure may be attached to the carrier by means of an adhesive layer or mechanically, for instance. The tape-like structure may be implemented such that it comprises a first adhesive layer for attaching the substrate to the tape-like structure and a second adhesive layer for attaching the tape-like structure to the carrier. Alternatively, substrates may be attached both to the first and to the second adhesive layer of the tape-like structure.

In accordance with a variation which is not an embodiment of the current invention, the carrier may be formed from the tape-like structure alone, in other words, the carrier is the tape-like structure. This tape-like structure may comprise a base material and, on a first side of the base material, a first adhesive layer to which one or more substrates are attachable. The tape-like structure may further comprise, on its second side, a second adhesive layer, to which one or more substrates are attachable. The tape-like structure or the tape may be flexible or rigid. A flexible tape may be folded in a folded form and hence the substrates may be attached between the folds, whereby it is possible to place a plurality of substrates in cassette-like order side by side. The flexible tape may also be bent into a spiral or some other bent shape in order for the substrates to be attached between the spiral rings or folds.

The tape comprising a base material having a first and a second side, of which first and second sides at least one is furnished with an adhesive, may be used as a substrate carrier for processing the substrate in the reaction chamber of the gas deposition apparatus by exposing the substrate to alternate, saturated surface reactions of starting materials.

By the arrangement and carrier of the present invention it is possible to achieve three significant objectives. The adhesive or the tape-like structure enables the substrates to be placed in the reaction chamber and processing in the reaction chamber in substantially vertical position or in a position between the vertical and the horizontal positions without complicated solutions provided in the substrate carrier. In other words, the adhesive or the tape permits to place the substrate at will in a desired position inside the reaction chamber using an easy and simple solution. At the same time, when the adhesive or the tape attaches the substrate to the substrate support or carrier, it also prevents backside deposition of the coating or formation of the coating on the substrate area that is in connection with the adhesive or the adhesive layer of the tape. Further, by selecting an area, location or shape wherewith the adhesive or the adhesive of the tape is in contact, it is possible to make a desired selection such that, apart from substrate attachment, the adhesive or the adhesive layer may be used as a mask to prevent the coating from depositing onto the predetermined area or location on the substrate.

It is obvious to a person skilled in the art that as technology advances the basic idea of the invention may be implemented in a variety of ways. Thus, the invention and the embodiments thereof are not limited to the above examples, but they may vary within the scope of the claims.

## Claims

1. An arrangement for processing a substrate in a gas deposition apparatus by exposing the substrate to alternate surface reactions of starting materials, the arrangement comprising a carrier on which the substrate is introduced into the gas deposition apparatus, the substrate being arranged for attachment to the carrier with an adhesive, **characterized in that** the carrier is a cassette-like structure comprising a plurality of mounting supports formed of adjacent planes, each plane including a base material, and on at least a first side of the base material a first adhesive layer to which the substrates are attachable so that the adhesive layer masks a part of each attached substrate while the substrate is exposed to the alternate saturated surface reactions of the starting materials.

2. The arrangement of claim 1, **characterized in that** the mounting support comprises a second adhesive layer on the second side of the base material.

3. The arrangement of any one of claims 1 or 2, **characterized in that** the arrangement comprises automated loading means for loading the substrate into the gas deposition apparatus on the carrier.

4. The arrangement of any one of claims 1 to 3, **characterized in that** the first adhesive layer is arranged to substantially prevent the exposure of the substrate to the surface reactions on the areas covered by the first adhesive layer.

5. The arrangement of claim 4, **characterized in that** the first adhesive layer is arranged to attach the substrate tightly to the base such that it prevents backside deposition produced by surface reactions on the adhesive attachment area.

6. A carrier for supporting a substrate in a gas deposition apparatus as the substrate is processed by exposing it to alternate surface reactions of starting materials, the carrier comprising an adhesive layer for attaching the substrate to the carrier, **characterized in that** the carrier is a cassette-like structure comprising a plurality mounting supports formed of adjacent planes, each plane including a base material and on at least a first side of the base material a first adhesive layer to which one or more substrates are attachable so that the adhesive layer masks a part of the substrate while the substrate is exposed to the alternate saturated surface reactions of the starting materials.

7. The carrier of claim 6, **characterized in that** the cassette-like structure further comprises, on its second side, a second adhesive layer to which one or more substrates are attachable.

## Patentansprüche

1. Anordnung zur Bearbeitung eines Substrats in einer Gasphasenabscheidungsvorrichtung, indem das Substrat wechselnden Oberflächenreaktionen von Ausgangsmaterialien unterzogen wird, wobei die Anordnung einen Träger umfasst, auf welchem das Substrat in die Gasphasenabscheidungsvorrichtung eingetragen wird, wobei das Substrat eingerichtet ist, um mit einem Haftmittel auf dem Träger befestigt zu werden, **dadurch gekennzeichnet, dass** der Träger eine kassettenartige Struktur ist, die eine Mehrzahl von aus benachbarten Ebenen gebildeten Montageauflagen umfasst, wobei jede Ebene ein Basismaterial und auf mindestens einer ersten Seite des Basismaterials eine erste Haftmittelschicht, an welcher die Substrate befestigt werden können, beinhaltet, so dass die Haftmittelschicht einen Teil jedes befestigten Substrats verdeckt, während das Substrat den wechselnden gesättigten Oberflächenreaktionen des Ausgangsmaterials ausgesetzt ist.

2. Anordnung nach Anspruch 1, **dadurch gekennzeichnet, dass** die Montageauflage eine zweite Haftmittelschicht auf der zweiten Seite des Basismaterials umfasst.

3. Anordnung nach einem der Ansprüche 1 oder 2, **dadurch gekennzeichnet, dass** die Anordnung automatisierte Beschickungsmittel umfasst, um das Substrat in die Gasphasenabscheidungsvorrichtung auf dem Träger einzuführen.

4. Anordnung nach einem der Ansprüche 1 bis 3, **dadurch gekennzeichnet, dass** die erste Haftmittelschicht so angeordnet ist, dass sie im Wesentlichen verhindert, dass das Substrat in den von der ersten Haftmittelschicht bedeckten Bereichen den Oberflächenreaktionen ausgesetzt ist.

5. Anordnung nach Anspruch 4, **dadurch gekennzeichnet, dass** die erste Haftmittelschicht so angeordnet ist, dass sie das Substrat fest an der Basis befestigt, so dass eine durch Oberflächenreaktionen erzeugte rückseitige Abscheidung im Haftbefestigungsbereich verhindert wird.

6. Träger zum Stützen eines Substrats in einer Gasphasenabscheidungsvorrichtung, während das Substrat bearbeitet wird, indem es wechselnden Oberflächenreaktionen von Ausgangsmaterialien ausgesetzt wird, wobei der Träger eine Haftmittelschicht zum Befestigen des Substrats am Träger umfasst, **dadurch gekennzeichnet, dass** der Träger eine kassettenartige Struktur ist, die eine Mehrzahl von aus benachbarten Ebenen gebildeten Montageauflagen umfasst, wobei jede Ebene ein Basismaterial und auf mindestens einer ersten Seite des Basismaterials eine erste Haftmittelschicht, an welcher ein oder mehrere Substrate befestigt werden können, beinhaltet, so dass die Haftmittelschicht einen Teil des Substrats verdeckt, während das Substrat den wechselnden gesättigten Oberflächenreaktionen der Ausgangsmaterialien ausgesetzt ist.

7. Träger nach Anspruch 6, **dadurch gekennzeichnet, dass** die kassettenartige Struktur auf ihrer zweiten Seite ferner eine zweite Haftmittelschicht umfasst, an welcher ein oder mehrere Substrate befestigt werden können.

## Revendications

1. Agencement pour le traitement d'un substrat dans un dispositif de dépôt en phase vapeur par l'exposition du substrat à des réactions de surface alternées de matières de départ, ledit agencement comprenant un support sur lequel le substrat est introduit dans le dispositif de dépôt en phase vapeur, ledit substrat étant agencé de manière à être attaché au support avec un adhésif, **caractérisé en ce que** le support est une structure en forme de cassette comprenant une pluralité d'appuis de montage formés de plans adjacents, chacun desdits plans comportant une matière de base et, au moins sur un premier côté de la matière de base, une première couche adhésive à laquelle les substrats peuvent être attachés de sorte que la couche adhésive masque une partie de chaque substrat attaché pendant que le substrat est exposé aux réactions de surface saturées alternées des matières de départ.

2. Agencement selon la revendication 1, **caractérisé en ce que** l'appui de montage comprend une deuxième couche adhésive sur le deuxième côté de la matière de base.

3. Agencement selon l'une des revendications 1 ou 2, **caractérisé en ce que** l'agencement comprend des moyens de chargement automatisés pour introduire le substrat dans le dispositif de dépôt en phase vapeur sur le support.

4. Agencement selon l'une des revendications 1 à 3, **caractérisé en ce que** la première couche adhésive est agencée de manière à empêcher essentiellement l'exposition du substrat aux réactions de surface dans les zones recouvertes par la première couche adhésive.

5. Agencement selon la revendication 4, **caractérisé en ce que** la première couche adhésive est agencée de manière à attacher le substrat solidement à la base afin d'empêcher un dépôt en face arrière par des réactions de surface dans la zone d'attache adhésive.

6. Support pour appuyer un substrat dans un dispositif de dépôt en phase vapeur pendant que le substrat est traité par exposition du substrat à des réactions de surface alternées de matières de départ, ledit support comprenant une couche adhésive pour attacher le substrat au support, **caractérisé en ce que** le support est une structure en forme de cassette comprenant une pluralité d'appuis de montage formés de plans adjacents, chacun desdits plans comportant une matière de base et, au moins sur un premier côté de la matière de base, une première couche adhésive à laquelle un ou plusieurs substrats peuvent être attachés de sorte que la couche adhésive masque une partie du substrat pendant que le substrat est exposé aux réactions de surface saturées alternées des matières de départ.

7. Support selon la revendication 6, **caractérisé en ce que** la structure en forme de cassette, sur son deuxième côté, comprend également une deuxième couche adhésive à laquelle un ou plusieurs substrats peuvent être attachés.
